# EUROPÄISCHE PATENTSCHRIFT

(11) **EP 1 231 474 B1**
(45) Veröffentlichungstag und Bekanntmachung des Hinweises auf die Patenterteilung: **02.06.2010**
(21) Anmeldenummer: 02450025.8
(22) Anmeldetag: 06.02.2002
(51) Int. Cl.: G01R 1/073, G01R 3/00, G01R 35/00, B23P 19/00, B23P 19/02, B25B 27/00, B25B 27/14, B25B 27/20

(54) **Verfahren und Vorrichtung zum Lokalisieren von möglicherweise fehlerhaften Stiften in einem Prüfadapter**
Method and apparatus for locating faulty pins in a test adapter
Procédé et apparail de localisation de broches défectueuses d'un adapteur de test

(30) Priorität: 12.02.2001 AT 2062001
(43) Veröffentlichungstag der Anmeldung: 14.08.2002
(73) Patentinhaber: AT & S AUSTRIA TECHNOLOGIE & SYSTEMTECHNIK Aktiengesellschaft, A-8700 Leoben-Hinterberg (AT)
(72) Erfinder: Baumgartner, Friedrich, 8753 Fohnsdorf (AT)
(74) Vertreter: Weinzinger, Arnulf

(56) Entgegenhaltungen:
- EP-A- 0 194 695
- EP-A- 0 859 239
- EP-A- 0 994 359
- WO-A-98/21597
- DE-A- 3 312 436
- DE-A- 3 722 485
- DE-A- 4 242 837
- DE-A- 19 716 945
- DE-U- 8 907 245
- US-A- 3 654 824
- US-A- 4 050 148
- US-A- 4 052 788
- US-A- 4 620 366
- US-A- 4 926 119
- US-A- 4 963 822
- US-A- 5 408 189
- US-A- 5 537 736
- "HEATSINK REMOVAL TOOL" IBM TECHNICAL DISCLOSURE BULLETIN, IBM CORP. NEW YORK, US, Bd. 38, Nr. 2, 1. Februar 1995 (1995-02-01), Seite 173, XP000502433 ISSN: 0018-8689

## Beschreibung

Die Erfindung betrifft ein Verfahren sowie eine Vorrichtung zum Lokalisieren von möglicherweise fehlerhaften Stiften in einem Prüfadapter, der zum Testen von Leiterplatinen in einen Tester eingesetzt wird.

Weiters bezieht sich die Erfindung auf ein Stiftwerkzeug zum Ziehen eines so lokalisierten Stiftes aus einem Prüfadapter.

Prüfadapter zum Testen von Leiterplatinen sind bekannt, vgl. beispielsweise EP 994 359 A2. Dabei ist es auch bekannt, die Prüfadapter mit Stiften oder Nadeln auszurüsten, die beim Testen von Leiterplatinen in einem Tester einen elektrischen Kontakt zu Prüfpunkten der jeweiligen Leiterplatine herstellen. Wird im Zuge dieser Überprüfung der Leiterplatine ein Fehler im Zusammenhang mit der Kontaktherstellung und dem dabei herbeizuführenden Schaltungsverhalten festgestellt, so muss überprüft werden, ob tatsächlich ein Fehler in der Leiterplatine vorliegt, oder ob nicht der entsprechende Stift des Prüfadapters fehlerhaft ist. Dabei ist es schwierig und zeitaufwendig, den jeweiligen Prüfstift im bestückten Prüfadapter zu suchen, wobei es zu einem Maschinenstillstand kommt, der dementsprechend lang dauert und zu Verzögerungen beim Testen der Leiterplatinen führt. Außerdem ist der jeweilige Prüfstift, sofern er in seiner Position festgestellt werden kann, auch nur mit aufwendigen Manipulationen zu tauschen. Zu bedenken ist dabei, dass die Stifte beispielsweise in Abständen von unter 2 mm oder aber - auf der Kontaktierungsseite - sogar von bloß ca. 0,5 mm vorliegen können. Es ist somit verständlich, dass bei einer derartig engen Stiftanordnung die Stiftsuche und das Auswechseln der Stifte außerordentlich schwierig ist.

Es ist daher Aufgabe der Erfindung, hier Abhilfe zu schaffen und ein Verfahren sowie eine Vorrichtung zum Lokalisieren von fehlerhaften Stiften in einem solchen Prüfadapter vorzusehen, mit dem bzw. mit der rasch und sicher die jeweiligen Stifte in ihrer Position erfasst und auch angezeigt werden können, um ein einfaches und sicheres Ziehen der Stifte, insbesondere zu ihrem Auswechseln, zu ermöglichen.

Im Zusammenhang damit ist es weiters Aufgabe der Erfindung, ein besonderes Stiftziehwerkzeug vorzusehen, mit dem die lokalisierten und angezeigten Stifte auf einfache Weise aus dem Prüfadapter entfernt werden können.

Das erfindungsgemäße Verfahren der eingangs angeführten Art ist dadurch gekennzeichnet, dass vom Tester ausgegebene Koordinaten von Fehlerstellen einer X-Y-Steuerung einer Antriebseinrichtung zugeführt werden, die eine entsprechende X-Y-Relativbewegung zwischen einem Lichtsender und dem Prüfadapter herbeiführt, wobei mit Hilfe des so in die durch die Koordinaten gegebene Position in Ausrichtung zum jeweiligen Stift gebrachten Lichtsenders der Stift durch Beleuchten angezeigt wird.

In entsprechender Weise ist die erfindungsgemäße Vorrichtung gekennzeichnet durch eine Auflage für den Prüfadapter, mit der eine Antriebseinrichtung für eine Lichtquelle verbunden ist, welcher eine X-Y-Steuerung mit Koordinatendaten-Zuführeinheit zugeordnet ist.

Die Erfindung macht sich zu Nutze, dass beim Testen von Leiterplatinen im Falle der Entdeckung eines Fehlers, welcher außer der Leiterplatine auch dem Stift im Prüfadapter zugeordnet werden könnte, die Koordinaten der Fehlerstelle im Tester bekannt sind. Ein derartiger Tester zeigt nämlich üblicherweise die fehlerhafte Stelle auf der Leiterplatine - und demgemäß natürlich auch die entsprechende Position am Prüfadapter - in Koordinaten an, und genau diese Koordinatenangabe kann in der Folge - beim Trennen des Prüfadapters von der Leiterplatine - zum Anzeigen des in der jeweiligen Position befindlichen Stiftes im Prüfadapter verwendet werden. Dabei werden mit Hilfe der Koordinaten der Fehlerstelle die X-Y-Koordinaten für einen Lichtsender (vorzugsweise einen Laserpointer) erhalten, und dieser Lichtsender wird entsprechend den X- bzw. Y-Koordinaten in die jeweilige Position relativ zum Prüfadapter gesteuert, so dass er nach Bewegung in diese Position mit einem engen Lichtstrahl den Stift an jener Stelle beleuchtet, der der festgestellten Fehlerposition entspricht. Der durch Beleuchten angezeigte Stift kann dann aus dem Prüfadapter gezogen werden, damit er überprüft oder aber, im Falle eines fehlerhaften Stiftes, gegen einen anderen Stift ausgewechselt wird. Auf diese Weise wird eine beträchtliche Zeitersparnis erzielt, und überdies werden die Adapterplatten und Adapterrahmen geschont. Die Zeitersparnis wird dabei auch dann erzielt, wenn der Prüfadapter - wie dies bevorzugt vorgesehen ist - zum Lokalisieren des jeweiligen Stiftes aus dem Leiterplatinen-Tester entfernt und in einer eigenen Vorrichtung, die die vorerwähnte Auflage für einen Prüfadapter aufweist, angeordnet wird. In dieser Vorrichtung kann nicht nur der gesuchte Stift mit Hilfe des X-Y-gesteuerten Lichtsenders rasch aufgefunden und optisch angezeigt werden, es ist auch der Stift dann ohne Behinderung durch andere Komponenten frei zugänglich, so dass er rasch gezogen werden kann. Während dieser Zeit können am Leiterplatinen-Tester andere Tätigkeiten, wie Reinigungen, Federstiftwechsel usw., vorgenommen werden.

Um den Lichtsender exakt in die jeweilige X-Y-Position zu bewegen, wird bevorzugt vorgesehen, dass die Antriebseinrichtung zwei zueinander rechtwinkelig angeordnete Linearantriebe, insbesondere Spindeltriebe mit Schrittmotoren, enthält, die an die X-Y-Steuerung angeschlossen sind. Gegebenenfalls können die Linearantriebe aber auch mit Ketten oder Seilen (ohne Dehnung) realisiert werden.

Für eine exakte Ausrichtung des Prüfadapters zur Lichtsender-Einrichtung ist es vorteilhaft, wenn die Auflage Anlage- und/oder Zentrierelemente für eine automatische Ausrichtung und Zentrierung des Prüfadapters aufweist. Da an sich der Prüfadapter weiters unterschiedliche Größen haben und in verschiedenen Lagen (z.B. Unterseite nach oben) und Ausrichtungen (links/rechts vertauscht) auf der Auflage angebracht werden kann, ist es ferner günstig, wenn der Auflage zumindest ein Sensor zur Erkennung des Adapter-Formats und/oder der Lage und/oder der Ausrichtung des Adapters relativ zur Auflage zugeordnet ist.

Um einen besonders scharfen und hellen Lichtpunkt am Kopf des jeweiligen Stiftes herbeizuführen, hat es sich auch wie bereits erwähnt als vorteilhaft herausgestellt, wenn die Lichtquelle durch einen Laserpointer gebildet ist.

Um die am Leiterplatinen-Tester erhaltenen X-Y-Koordinatendaten der X-Y-Steuerung zuzuführen, kann eine eigene Tastatur vorgesehen sein, die mit der X-Y-Steuerung für die Lichtsender-Antriebseinrichtung verbunden ist. Um eine derartige gesonderte händische Eingabe zu erübrigen, kann andererseits auch vorgesehen werden, dass die X-Y-Koordinatendaten der X-Y-Steuerung direkt über einen Rechner, nämlich den Rechner, der dem Leiterplatinen-Tester zugeordnet ist, zugeführt werden. Weiters können die Koordinatendaten aber auch mit Hilfe eines Barcode-Scanners eingegeben werden.

Das erfindungsgemäße Stiftziehwerkzeug zeichnet sich durch einen einfachen Aufbau mit einer Hülse aus, die einen Griffteil sowie innen an den Stiftkopf angepasste Innenabmessungen aufweist, um den Stiftkopf reibungsschlüssig zu erfassen, damit der Stift aus dem Prüfadapter gezogen werden kann.

Um das Einführen der Hülse in die Öffnung, in der der Stiftkopf vorliegt, zu erleichtern, ist es weiters vorteilhaft, wenn die Hülse außen sich zum freien Ende hin verjüngend ausgeführt ist. Die Hülse ist vorzugsweise einstückig. Für die dauerhafte Ausbildung der Hülse ist es weiters günstig, wenn die Hülse aus einem Metall, z.B. Titan oder Stahl, besteht.

Um das Stiftziehwerkzeug gut ergreifen zu können, ist es auch von Vorteil, wenn der Griffteil gegenüber der übrigen Hülse ein größeres Außenmaß aufweist. Auch ist es hier vorteilhaft, wenn auf dem Griffteil eine Auflage aus Kunststoff oder Gummi aufgebracht ist.

Wenn ein Stift mit seinem Kopf beim Ziehen zu fest in der Hülse stecken bleiben sollte, kann dann, wenn die Hülse eine sich über ihre gesamte axiale Länge erstreckende, hindurchgehende Bohrung hat, der Stift von der Rückseite der Hülse her mit einem Dorn herausgeschoben werden.

Mit der vorliegenden Technik wird somit bei Feststellen eines Fehlers beim Testen einer Leiterplatine mit Hilfe eines Stift-Prüfadapters derart vorgegangen, dass der Prüfadapter aus dem Leiterplatinen-Tester genommen und in der Suchgerät-Vorrichtung auf die dort vorgesehene Auflage gelegt wird. Dabei ergibt sich in der bevorzugten Ausführungsform beim Auflegen selbsttätig eine Zentrierung, und es wird auch erkannt, in welcher Lage der Adapter auf die Auflage aufgelegt wurde. Alle Schritte bei der Stiftsuche erfolgen außerhalb und getrennt vom Leiterplatinen-Tester. Die vom Tester gelieferten Koordinaten werden beispielsweise über die Eingabetastatur, über den Scanner oder aber auch selbsttätig auf Befehl von einem dem Tester zugehörigen Rechner eingegeben und der X-Y-Steuerung für die Lichtquellen-Antriebseinrichtung zugeführt. Dabei wird automatisch je nach Ausrichtung (normal/180° verdreht) und Lage (Oberseite des Prüfadapters nach oben oder unten) eine entsprechende Umrechnung der X-Y-Koordinaten (vergleichbar einer Spiegelung) oder deren direkten Übernahme vorgenommen. Danach wird der Lichtsender an die entsprechende X-Y-Stelle bewegt, indem die beiden Antriebseinrichtungen angesteuert bzw. aktiviert werden, und der Lichtsender markiert den an dieser Stelle befindlichen Stift mit einem scharfen Lichtpunkt. Der Stift kann nun mit Hilfe des Stiftwerkzeuges entfernt bzw. getauscht werden. Danach kann der Prüfadapter wieder in den Leiterplatinen-Tester eingesetzt werden.

Die Erfindung wird nachfolgend anhand von in der Zeichnung dargestellten bevorzugten Ausführungsbeispielen, auf die sie jedoch nicht beschränkt sein soll, noch weiter erläutert. Es zeigen:
Fig. 1 schematisch die Anordnung einer Leiterplatine in einem Tester, wobei ein oberer und ein unterer Prüfadapter zum Kontaktieren von Kontaktflächen an der Ober- und Unterseite der Leiterplatine vorgesehen sind;
Fig. 2 schematisch die Anordnung eines Prüfadapters auf einer Suchtisch-Auflage der erfindungsgemäßen Vorrichtung zum Lokalisieren von Stiften;
Fig. 3 schematisch in einer schaubildlichen Darstellung einen Prüfadapter während des Lokalisierens von Stiften, wobei oberhalb des Prüfadapters ein Rahmen mit einer X-Y-Steuerung für einen Laserpointer veranschaulicht und weiters schematisch ein Rechner für die Zuführung von Koordinatendaten gezeigt ist;
Fig. 3A schematisch eine Draufsicht auf einen Teil eines Rasters, in dem die Stifte in einem Prüfadapter vorliegen können;
Fig. 4 eine schematische Ansicht einer Vorrichtung zum Lokalisieren von Stiften in einem Adapter samt Auflage und X-Y-Steuerung für einen Laserpointer;
Fig. 5 eine zu Fig. 4 gehörige schematische Draufsicht auf die Vorrichtung;
Fig. 6 eine schematische Ansicht der Auflage der Vorrichtung gemäß Fig. 4 und 5, zur Veranschaulichung der Aufnahme von verschiedenen Adapterformaten sowie der Anordnung von Sensoren zur Erfassung des jeweils eingesetzten Prüfadapters;
Fig. 7 schematisch einen Querschnitt durch die X-Achse der X-Y-Steuerung zur Veranschaulichung des Laserpointers, der einen Kopf eines Stiftes beleuchtet;
Fig. 8 eine Ansicht eines einstückigen Stiftziehwerkzeuges in Form einer abgesetzt ausgebildeten Hülse mit durchgehender innerer Bohrung; und
Fig. 9 den Einsatz dieses Stiftziehwerkzeuges beim Ziehen eines Stiftes aus dem Prüfadapter.

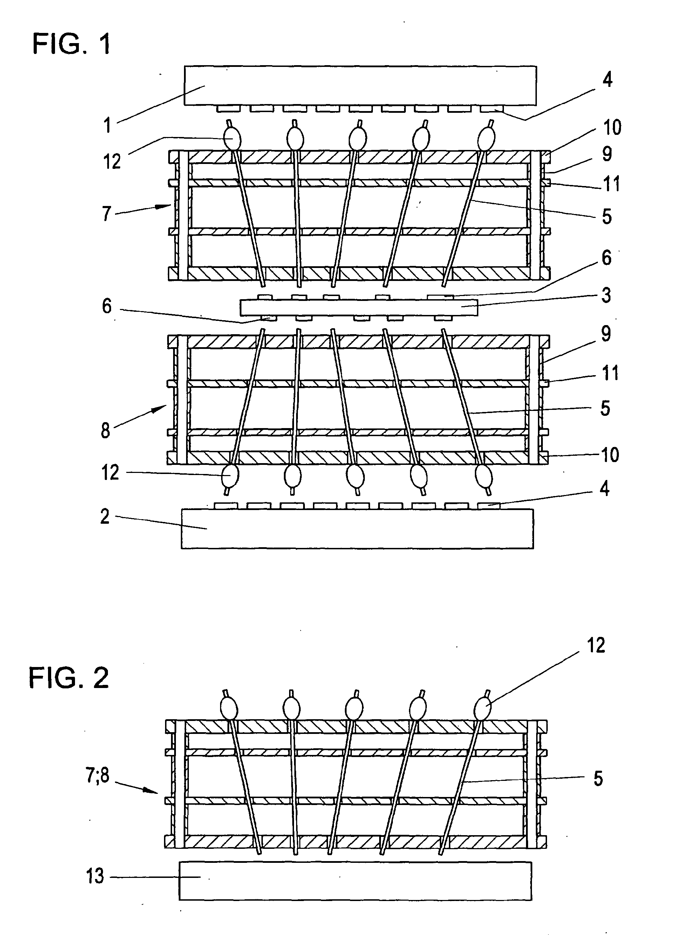

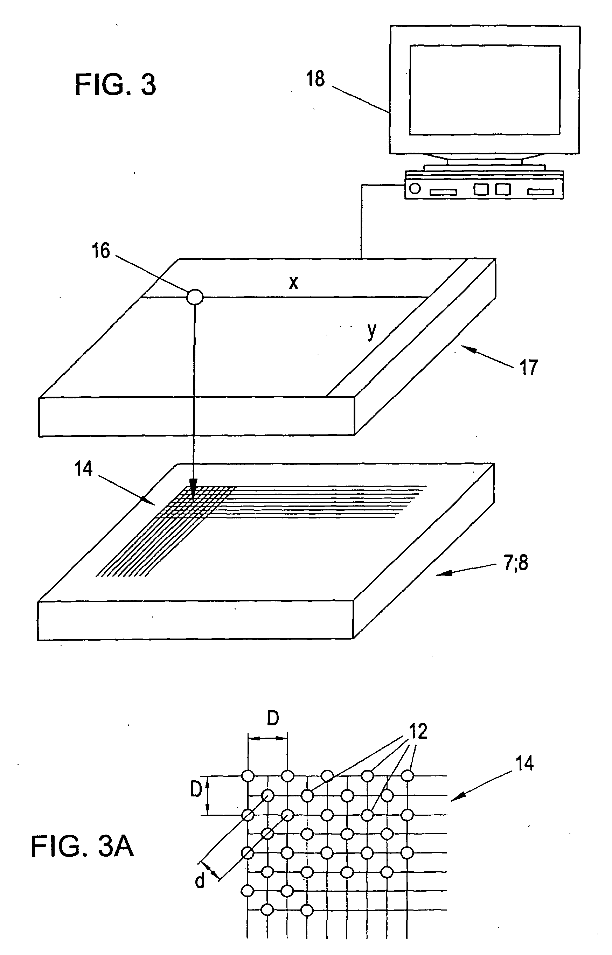

In Fig. 1 sind bei 1 und 2 ein oberes bzw. unteres Testfeld einer Prüfmaschine, auch Tester genannt, veranschaulicht. Ein derartiger Tester, mit den Testfeldern 1, 2, dient zum Überprüfen einer beidseitig mit Leiterbahnen versehenen Leiterplatine 3. Die Testfelder 1, 2 haben Kontaktzonen 4, die mit den einen Enden von Stiften 5 in Kontakt treten, deren andere Enden die Leiterbahnen 6 der Leiterplatine 3 an den gewünschten Stellen kontaktieren. Um die Stifte 5 auf die gewünschten Leiterbahnen 6 oder allgemein Metallflächen der Leiterplatine 3 zu richten, sind ein oberseitiger Prüfadapter 7 und ein unterseitiger Prüfadapter 8 vorgesehen. Jeder Prüfadapter 7, 8 besteht beispielsweise aus mehreren durch Distanzhalter 9 in Abständen voneinander gehaltenen Platten, z.B. 10, 11, um die Stifte 5 in der gewünschten Weise auszurichten. An der Stiftaustrittseite, benachbart der Leiterplatine 3, können die Stifte in Abständen von bloß 0,4 mm vorliegen. An der Stifteintrittseite, d.h. auf der dem jeweiligen Testfeld 1 bzw. 2 zugewandten Seite, liegen die Stiftpositionen in größeren Abständen vor (es müssen in der Praxis bei einer bestimmten Leiterplatine nicht immer alle Positionen mit einem Stift besetzt sein), und zwar in einem vorgegebenen Raster, wie dies nachfolgend anhand der Fig. 3A noch erläutert werden wird. An dieser Stifteintrittseite ergibt sich ein Stiftabstand von ca. 1,8 mm beim gezeigten Ausführungsbeispiel.

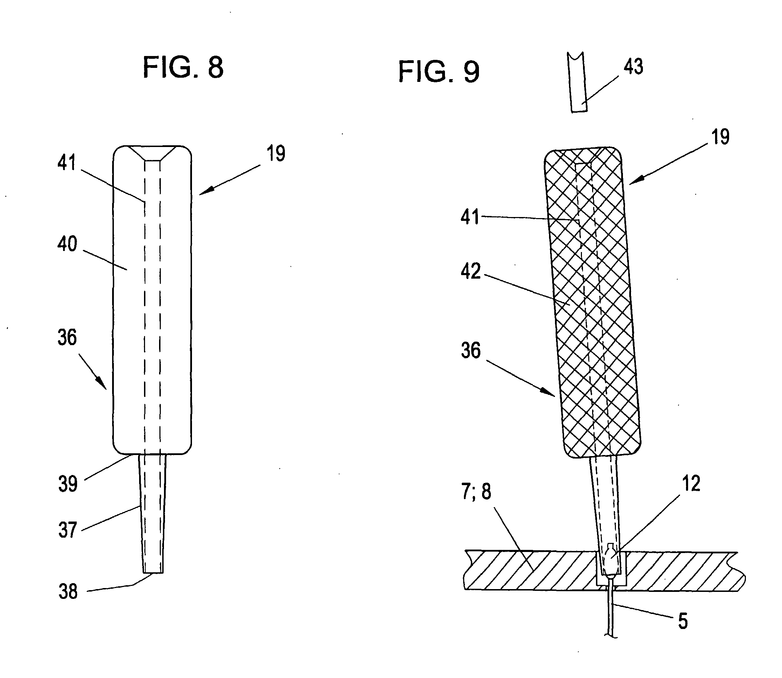

Wie weiters aus Fig. 1 ersichtlich sind die Stifte 5 an der Austrittseite mit einem ihr Ergreifen erleichternden Kopf 12 versehen. Dieser Kopf 12 ermöglicht in besonders vorteilhafter Weise das Ziehen des jeweiligen Stiftes 5 mit Hilfe eines hülsenförmigen Stiftziehwerkzeuges, wie nachfolgend noch näher anhand der Fig. 8 und 9 erläutert werden wird.

In Fig. 2 ist schematisch die Anordnung eines Prüfadapters 7 oder 8 auf einer Auflage 13 einer Vorrichtung zum Lokalisieren von Stiften 5 veranschaulicht. Wie ersichtlich wird der jeweilige Prüfadapter 7 oder 8 derart auf der Auflage 13 angebracht, dass die Stifte 5 mit den Köpfen 12 nach oben, von der Auflage 13 weg, gerichtet sind.

Es sei erwähnt, dass die Darstellungen in den Figuren 1 und 2, vor allem was die Anzahl der Stifte 5 anlangt, nur ganz schematisch ist, und dass in der Praxis wesentlich mehr Stifte pro Prüfadapter, z.B. einige tausend Stifte, vorliegen können. Diese große Anzahl und die engen Abstände zwischen den Stiften machen deutlich, dass es schwierig ist, im Fall der Feststellung eines Fehlers beim Testen der Leiterplatine 3 genau jenen Stift 5, der abgesehen von einem eventuellen Fehler an der Leiterplatine 3 fehlerhaft sein könnte, zu lokalisieren. Andererseits ist es bei den bekannten Testern mit den Testfeldern 1, 2 üblich, dass bei Feststellen eines Fehlers beim Testen der Leiterplatine 3 elektronisch entsprechende X-Y-Koordinaten - für den jeweiligen Stift 5 - festgehalten werden. Dieser Umstand kann nun ausgenützt werden, um in einer eigenen Suchvorrichtung, mit der Auflage 13, den jeweils eine fehlerhafte Position definierenden Stift zu lokalisieren und aus dem jeweiligen Prüfadapter 7 bzw. 8 zwecks Überprüfung oder Austauschens zu entfernen.

In Fig. 3 ist schematisch veranschaulicht, wie oberhalb eines Prüfadapters 7 bzw. 8, mit an seiner Oberseite gemäß einem vorgegebenen Raster 14 angeordneten Stiftköpfen 12 (s. auch Fig. 3A), in einem mit der in Fig. 3 nicht näher gezeigten Auflage 13 für den Prüfadapter 7 bzw. 8 fest verbundenen Rahmen eine Antriebs- und Steuereinrichtung 17 für eine X-Y-Bewegung eines als Lichtsender vorgesehenen Laserpointers 16 angebracht ist. Der X-Y-Steuerung 17 werden über eine Rechnereinheit 18, der die Koordinaten des gesuchten Stiftes 5 zugeführt oder eingegeben werden, entsprechende Steuersignale für die in Fig. 3 nicht näher gezeigte eigentliche Antriebseinrichtung für den Laserpointer 16 zugeführt. Die Koordinatendaten können vom Tester 1, 2 der Rechnereinheit 18 direkt zugeleitet werden, oder aber es können die Koordinatendaten händisch oder aber mit Hilfe eines Strichcodes eingegeben werden.

Aus Fig. 3A ist ersichtlich, dass auf der oben erwähnten Eintrittseite des jeweiligen Prüfadapters 7 bzw. 8 die Köpfe 12 der Stifte 5 in einem vorgegebenen Raster mit horizontalen und vertikalen Abständen D von ca. 2,5 mm und mit diagonalen Abständen d in der Größenordnung von ca. 1,8 mm vorliegen. Durch Angabe der jeweiligen X- bzw. Y-Koordinaten (in horizontaler bzw. vertikaler Richtung wie in Fig. 3A) kann daher der jeweilige Stiftkopf 12 bzw. Stift 5 lokalisiert werden. Für diese Lokalisierung wird der Laserpointer 16 - oder allgemein ein einen Punkt-förmigen Lichtfleck kleinster Abmessungen erzeugender Lichtsender - in die erforderliche X-Y-Position gesteuert und eingeschaltet, so dass der gesuchte Stiftkopf 12 im Raster 14 beleuchtet wird. Durch dieses Beleuchten wird der gesuchte Stiftkopf 12 gut kenntlich gemacht, so dass er nunmehr mit Hilfe eines Stiftziehwerkzeuges 19, wie in Fig. 8 und 9 gezeigt, gezogen werden kann.

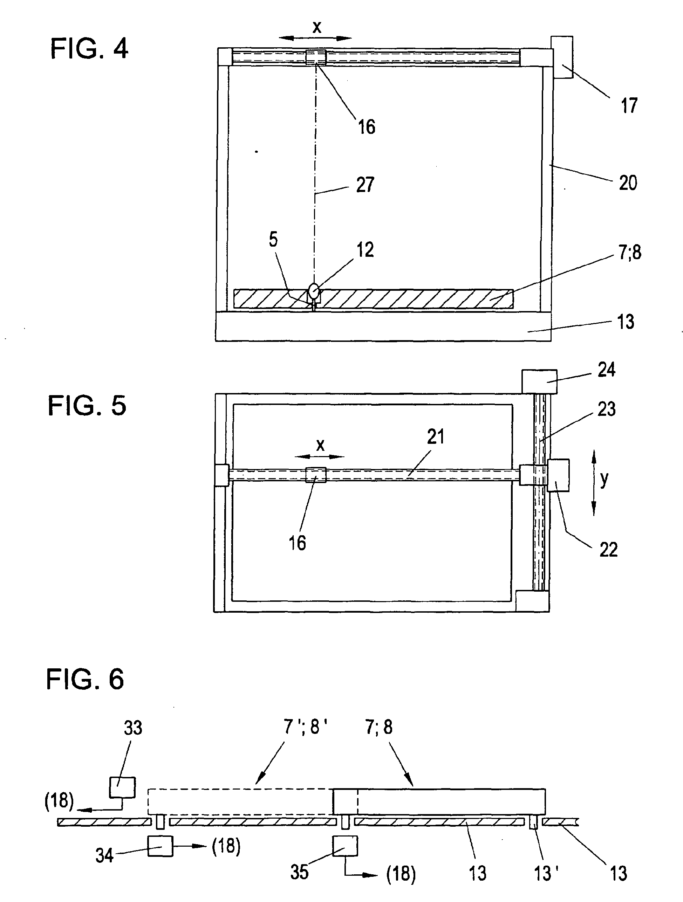

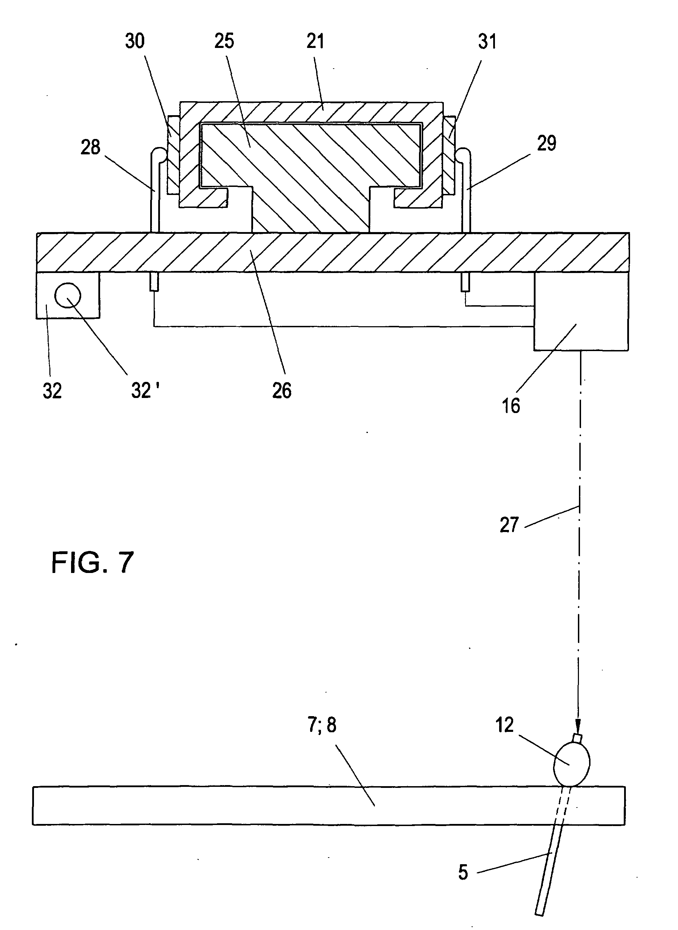

Aus Fig. 4 und 5 ist die vorliegende Vorrichtung zum Lokalisieren von Stiften 5 und zum Beleuchten von deren Stiftköpfen 12 mit Hilfe einer Lichtquelle, insbesondere eines Laserpointers 16, mehr im Detail veranschaulicht. Wie ersichtlich ist mit der Auflage 13 für den Prüfadapter 7 bzw. 8 über aufrechte Steher oder Wände 20 die X-Y-Steuerung 17 für den Laserpointer 16 verbunden. Im Einzelnen ist dabei der Laserpointer 16 in X-Richtung entlang einer im Querschnitt z.B. C-förmigen Führungsschiene 21 (s. Fig. 7) mit Hilfe eines Schrittmotors antreibbar, welcher seinerseits entlang einer entsprechenden Y-Führungsschiene mit Hilfe eines Schrittmotors 24 antreibbar ist (s. Fig. 5), wobei die X-Führungsschiene 21 samt Laserpointer 16 in der Y-Richtung zusammen mit dem Schrittmotor 22 mitbewegt wird.

Gemäß Fig. 7 ist innerhalb der Führungsschiene 21 ein Lagerschlitten 25 gleitend gelagert, und dieser Lagerschlitten 25 trägt eine Montageplatte 26, an der der Laserpointer 16 befestigt ist. In Fig. 7 ist auch veranschaulicht, wie der Laserpointer 16 den Kopf 12 eines Stiftes 5 in einem Prüfadapter 7 bzw. 8 mit einem Lichtstrahl 27 beleuchtet.

Zur Stromversorgung des Laserpointers 16 sind Schleifkontakte 28, 29 sowie Stromschienen 30, 31 längs der Führungsschiene 21 vorgesehen. Weiters ist aus Fig. 7 ein nur ganz schematisch angedeuteter Mitnehmer 32 ersichtlich, wobei es sich hierbei beispielsweise um eine Spindelmutter eines Spindelantriebs, wie an sich hinlänglich bekannt, oder aber auch um einen Mitnehmer, der mit einem Seilzug verbunden ist, handeln kann. Schematisch ist eine Spindel bzw. ein Seil in Fig. 7 bei 32' angedeutet.

In entsprechender Weise ist auch für die Antriebsbewegung in Y-Richtung, d.h. für das Antreiben des Schrittmotors 22 samt Führungsschiene 21, ein entsprechender, in der Zeichnung nicht näher ersichtlicher Spindeltrieb oder aber Seilzug, wie an sich bekannt, vorgesehen.

Mit Hilfe der genannten Schrittmotoren 22, 24 wird die erwähnte X-Y-Steuerung 17 bzw. Antriebseinrichtung (21 bis 25) für den Laserpointer 16 realisiert, wobei wie erwähnt von der Rechnereinheit 18 die entsprechenden Steuersignale an die Schrittmotoren 22, 24 angelegt werden, um den Laserpointer 16 in die jeweils vorgegebene X-Y-Position, zum Beleuchten des möglicherweise fehlerhaften Stiftes 5 bzw. dessen Kopfes 12, zu bewegen.

In einer vorteilhaften Ausführungsform ist der z.B. Tischförmigen Auflage 13 eine Mehrzahl von Sensoren 33, 34, 35 zugeordnet, und die Auflage 13 kann eine Größe haben, um Prüfadapter in verschiedenen Größen aufzunehmen, wobei Anlage- und/oder Zentrierelemente 13' vorgesehen sein können. Beispielsweise können zwei Adapterformate gegeben sein, wie in Fig. 6 bei 7;8 bzw. 7';8' angedeutet ist. Mit Hilfe der Sensoren 33, 35 kann daher das jeweils gegebene Adapterformat erkannt werden. Weiters kann mit Hilfe eines Sensors 34 auch erkannt werden, ob ein oberseitiger, in seiner Normalausrichtung vorliegender Prüfadapter 7 oder aber ein unterseitiger, um 180° gewendeter Prüfadapter 8 vorliegt. Im letzteren Fall müssen beispielsweise im gezeigten Ausführungsbeispiel die Koordinaten in Y-Richtung gespiegelt werden, bevor die X-Y-Steuerung zur Bewegung des Laserpointers 16 in die gewünschte Position angesteuert wird.

Zum Ziehen des lokalisierten Stiftes 5, mit dem Kopf 12, ist beispielsweise ein im Stiftziehwerkzeug 19 in Form einer Hülse 36 wie in Fig. 8 und 9 gezeigt vorgesehen. Diese das Stiftziehwerkzeug 19 bildende Hülse 36 ist beispielsweise einstückig aus Metall, insbesondere Titan oder Stahl, hergestellt, und sie weist einen vorderen Schaftteil 37 mit kleinem Querschnitt, insbesondere in der Größenordnung von 2 mm Außendurchmesser, auf. Dieser Schaftteil 37 ist zur freien Spitze 38 hin außen konisch verjüngt, und an seinem hinteren Ende geht er über eine Schulter 39 in einen verbreiterten Griffteil 40 über. Durch die gesamte Hülse 36 erstreckt sich eine Bohrung 41, beispielsweise mit einem Durchmesser von 1,4 mm. An der Spitze 38 beträgt der Außendurchmesser des Schaftteiles 37 beispielsweise 1,6 mm, so dass sich dort eine Wandstärke von 0,1 mm ergibt. Der Griffteil 40 kann einen Außendurchmesser von 6 mm haben. Der Griffteil 40 kann weiters, wie in Fig. 9 veranschaulicht, mit einer Kunststoffoder Gummiauflage 42 versehen sein, um das Ergreifen und Festhalten mit der Hand zu erleichtern. Die Hülse 36 wird zum Ziehen eines - beleuchteten - Stiftes 5 einfach über dessen Kopf 12 geschoben, wobei der Kopf 12 reibschlüssig in der Hülse 36 festgehalten wird. Dieses Festhalten kann durch leichtes Schrägstellen der Hülse 36 beim Ziehen des Stiftes 5 verstärkt werden.

Sollte ein Stift 5 mit seinem Kopf 12 zu fest in der Hülse 36 sitzen, wenn er aus dem Prüfadapter 7 bzw. 8 gezogen wurde, kann der Stift 5 von der Rückseite der Hülse 36 her durch die Bohrung 41 hindurch mit Hilfe eines in Fig. 9 nur ganz schematisch angedeuteten Dornes 43 ausgestoßen werden, wobei der Dorn 43 durch die sich durch die Hülse 36 hindurch erstreckende Bohrung 41 hindurch bewegt wird.

## Patentansprüche

1. Verfahren zum Lokalisieren von möglicherweise fehlerhaften Stiften (5) in einem Prüfadapter (7;8), der zum Testen von Leiterplatinen (3) in einen Tester (1;2) eingesetzt wird, **dadurch gekennzeichnet, dass** vom Tester ausgegebene Koordinaten von Fehlerstellen einer X-Y-Steuerung (17) einer Antriebseinrichtung (21-25) zugeführt werden, die eine entsprechende X-Y-Relativbewegung zwischen einem Lichtsender (16) und dem Prüfadapter (7;8) herbeiführt, wobei mit Hilfe des so in die durch die Koordinaten gegebene Position in Ausrichtung zum jeweiligen Stift (5) gebrachten Lichtsenders (16) der Stift (5) durch Beleuchten angezeigt wird.

2. Verfahren nach Anspruch 1, **dadurch gekennzeichnet, dass** der Prüfadapter (7;8) zum Lokalisieren der Stifte (5) aus dem Leiterplatinen-Tester entfernt wird, um die Stift-Lokalisierung durch Beleuchten vorzunehmen.

3. Verfahren nach Anspruch 1 oder 2, **dadurch gekennzeichnet, dass** der durch das Beleuchten mit dem Lichtsender (16) angezeigte Stift (5) aus dem Prüfadapter (7;8) außerhalb des Leiterplatinen-Testers entfernt und ersetzt wird.

4. Vorrichtung zum Lokalisieren von möglicherweise fehlerhaften Stiften in einem Prüfadapter (7;8), der zum Testen von Leiterplatinen (3) in einen Tester (1;2) eingesetzt wird, **gekennzeichnet durch** eine Auflage (13) für den Prüfadapter (7;8), mit der eine Antriebseinrichtung (21-25) für einen Lichtsender (16) verbunden ist, welcher eine X-Y-Steuerung (17) mit Koordinatendaten-Zuführeinheit (18) zugeordnet ist.

5. Vorrichtung nach Anspruch 4, **dadurch gekennzeichnet, dass** die Antriebseinrichtung (21-25) zwei zueinander rechtwinkelig angeordnete Linearantriebe enthält, die an die X-Y-Steuerung (17) angeschlossen sind.

6. Vorrichtung nach Anspruch 5, **dadurch gekennzeichnet, dass** die Linearantriebe durch Spindeltriebe mit Schrittmotoren (22, 24) gebildet sind.

7. Vorrichtung nach einem der Ansprüche 4 bis 6, **dadurch gekennzeichnet, dass** die Auflage (13) Anlage- und/oder Zentrierelemente (13') für eine automatische Ausrichtung und Zentrierung des Prüfadapters (7;8) aufweist.

8. Vorrichtung nach einem der Ansprüche 4 bis 7, **dadurch gekennzeichnet, dass** der Auflage (13) zumindest ein Sensor (33, 34, 35) zur Erkennung des Adapter-Formats und/oder der Lage und/oder der Ausrichtung des Prüfadapters (7;8) relativ zur Auflage (13) zugeordnet ist.

9. Vorrichtung nach einem der Ansprüche 4 bis 8, **dadurch gekennzeichnet, dass** der Lichtsender (16) durch einen Laserpointer gebildet ist.

10. Vorrichtung nach einem der Ansprüche 4 bis 9, **dadurch gekennzeichnet, dass** als Koordinatendaten-Zuführeinheit eine eigene Tastatur vorgesehen ist.

11. Vorrichtung nach einem der Ansprüche 4 bis 10, **dadurch gekennzeichnet, dass** als Koordinatendaten-Zuführeinheit ein der X-Y-Steuerung (17) zugeordneter Rechner (18) mit Tastatur vorgesehen ist.

12. Vorrichtung nach einem der Ansprüche 4 bis 9, **dadurch gekennzeichnet, dass** als Koordinatendaten-Zuführeinheit ein Barcode-Scanner vorgesehen ist.

13. Vorrichtung nach einem der Ansprüche 4 bis 12, in Kombination mit einem Stiftziehwerkzeug zum Ziehen eines lokalisierten Stiftes aus einem Prüfadapter (7; 8), welches Stiftziehwerkzeug eine mit einem Griffteil (40) versehene Hülse (36) aufweist, deren Innenabmessungen an den Stiftkopf (12) angepasst ist, um den Stiftkopf reibungsschlüssig zu erfassen.

14. Vorrichtung nach Anspruch 13, **dadurch gekennzeichnet, dass** die Hülse (36) außen sich zum freien Ende hin verjüngend ausgeführt ist.

15. Vorrichtung nach Anspruch 13 oder 14, **dadurch gekennzeichnet, dass** die Hülse (36) einstückig ist.

16. Vorrichtung nach einem der Ansprüche 13 bis 15, **dadurch gekennzeichnet, dass** die Hülse (36) aus einem Metall, z.B. Titan oder Stahl, besteht.

17. Vorrichtung nach einem der Ansprüche 13 bis 16, **dadurch gekennzeichnet, dass** der Griffteil (40) gegenüber der übrigen Hülse (36) ein größeres Außenmaß aufweist.

18. Vorrichtung, nach einem der Ansprüche 13 bis 17, **dadurch gekennzeichnet, dass** auf dem Griffteil (40) eine Auflage (42) aus Kunststoff oder Gummi aufgebracht ist.

19. Vorrichtung nach einem der Ansprüche 13 bis 18, **dadurch gekennzeichnet, dass** die Hülse (36) eine sich über ihre gesamte axiale Länge erstreckende, hindurchgehende Bohrung (41) hat.

## Claims

1. A method for locating possibly faulty pins (5) in a test adapter (7;8), which is inserted in a tester (1;2) for testing printed circuit boards (3), **characterized in that** coordinates of fault positions of an X-Y control (17), which are output by the tester, are supplied to a driving means (21-25), which causes an appropriate X-Y relative movement between a light emitter (16) and the test adapter (7;8), wherein the respective pin (5) is indicated by illumination by the aid of the light emitter (16) thus brought into the position in alignment with said pin determined by the coordinates.

2. A method according to claim 1, **characterized in that** the test adapter (7;8) for locating the pins (5) is removed from the printed circuit board tester to perform said locating of the pins by illumination.

3. A method according to claim 1 or 2, **characterized in that** the pin (5) indicated by illumination by the aid of the light emitter (16) is removed from the test adapter (7;8), and replaced, outside of the printed circuit board tester.

4. A device for locating possibly faulty pins in a test adapter (7;8) inserted in a tester (1;2) for testing printed circuit boards (3), **characterized by** a support (13) for the test adapter (7;8), which support is connected with a driving means (21-25) for a light emitter (16), an X-Y control (17) including a coordinate-data supplying unit (18) being associated with the driving means.

5. A device according to claim 4, **characterized in that** the driving means (21-25) comprises two linear drives arranged at a right angle relative to each other and connected to the X-Y control (17).

6. A device according to claim 5, **characterized in that** the linear drives are comprised of spindle drives including stepping motors (22, 24).

7. A device according to any one of claims 4 to 6, **characterized in that** the support (13) comprises abutment and/or centering elements (13') for the automatic alignment and centering of the test adapter (7;8).

8. A device according to any one of claims 4 to 7, **characterized in that** the support (13) is associated with at least one sensor (33, 34, 35) for the recognition of the adapter format and/or the position and/or the alignment of the test adapter (7;8) relative to the support (13).

9. A device according to any one of claims 4 to 8, **characterized in that** the light emitter (16) is formed by a laser pointer.

10. A device according to any one of claims 4 to 9, **characterized in that** a separate keyboard is provided as said coordinate-data supplying unit.

11. A device according to any one of claims 4 to 10, **characterized in that** a computer (18) including a keyboard and associated to the X-Y control (17) is provided as said coordinate-data supplying unit.

12. A device according to any one of claims 4 to 9, **characterized in that** a bar code scanner is provided as said coordinate-data supplying unit.

13. A device according to any one of claims 4 to 12 in combination with a pin extraction tool for extracting a located pin from a test adapter (7;8), which pin extraction tool comprises a sleeve (36) provided with a handle portion (40), the internal dimensions of the sleeve being adapted to the pin head (12) so as to seize said pin head by frictional engagement.

14. A device according to claim 13, **characterized in that** the sleeve (36) is externally configured to taper toward its free end.

15. A device according to claim 13 or 14, **characterized in that** the sleeve (36) is in one piece.

16. A device according to any one of claims 13 to 15, **characterized in that** the sleeve (36) is made of metal, e.g. titanium or steel.

17. A device according to any one of claims 13 to 16, **characterized in that** the handle portion (40) has a larger external dimension as compared to the remaining sleeve (36).

18. A device according to any one of claims 13 to 17, **characterized in that** a layer (42) of plastics or rubber is applied on the handle portion (40).

19. A device according to any one of claims 13 to 18, **characterized in that** the sleeve (36) comprises a throughgoing bore (41) extending over its total axial length.

## Revendications

1. Procédé pour localiser des broches (5) éventuellement défectueuses dans un adaptateur de vérification (7 ; 8), qui, pour tester des plaquettes de circuit imprimé (3), est inséré dans un testeur (1 ; 2), **caractérisé en ce que** des coordonnées de points de défaut délivrées par le testeur sont transmises à une commande X-Y (17) d'un dispositif d'entraînement (21-25), qui engendre un mouvement relatif X-Y correspondant entre un émetteur de lumière (16) et l'adaptateur de vérification (7 ; 8), de sorte qu'à l'aide de l'émetteur de lumière (16) ainsi amené à être orienté vers la broche (5) respectivement concernée, dans la position donnée par les coordonnées, cette broche (5) est indiquée en étant éclairée.

2. Procédé selon la revendication 1, **caractérisé en ce que** l'adaptateur de vérification (7 ; 8), pour la localisation des broches (5), est retiré du testeur de plaquettes de circuit imprimé, en vue d'effectuer la localisation des broches par éclairement.

3. Procédé selon la revendication 1 ou la revendication 2, **caractérisé en ce que** la broche (5) indiquée en étant éclairée par l'émetteur de lumière (16), est retirée de l'adaptateur de vérification (7 ; 8) et remplacée, à l'extérieur du testeur de plaquettes de circuit imprimé.

4. Installation pour localiser des broches éventuellement défectueuses dans un adaptateur de vérification (7 ; 8), qui, pour tester des plaquettes de circuit imprimé (3), est inséré dans un testeur (1 ; 2), **caractérisée par** un support d'appui (13) qui est destiné à l'adaptateur de vérification (7 ; 8) et auquel est relié un dispositif d'entraînement (21-25) pour un émetteur de lumière (16), une commande X-Y (17), qui comprend une unité d'amenée de données de coordonnées (18), étant associée audit dispositif d'entraînement.

5. Installation selon la revendication 4, **caractérisée en ce que** le dispositif d'entraînement (21-25) comprend deux entraînements linéaires agencés perpendiculairement l'un à l'autre, qui sont raccordés à la commande X-Y (17).

6. Installation selon la revendication 5, **caractérisée en ce que** les entraînements linéaires sont formés par des systèmes d'entraînement à vis avec moteurs pas à pas (22, 24).

7. Installation selon l'une des revendications 4 à 6, **caractérisée en ce que** le support d'appui (13) présente des éléments d'appui et/ou de centrage (13') pour une orientation et un centrage automatiques de l'adaptateur de vérification (7 ; 8).

8. Installation selon l'une des revendications 4 à 7, **caractérisée en ce qu'**au support d'appui (13) est associé au moins un détecteur (33, 34, 35) pour la reconnaissance du format d'adaptateur et/ou de la position et/ou de l'orientation de l'adaptateur de vérification (7 ; 8) par rapport au support d'appui (13).

9. Installation selon l'une des revendications 4 à 8, **caractérisée en ce que** l'émetteur de lumière (16) est formé par un pointeur laser.

10. Installation selon l'une des revendications 4 à 9, **caractérisée en ce qu'**en guise d'unité d'amenée de données de coordonnées, il est prévu un clavier spécifique.

11. Installation selon l'une des revendications 4 à 10, **caractérisée en ce qu'**en guise d'unité d'amenée de données de coordonnées, il est prévu un calculateur (18) avec clavier, qui est associé à la commande X-Y (17).

12. Installation selon l'une des revendications 4 à 9, **caractérisée en ce qu'**en guise d'unité d'amenée de données de coordonnées, il est prévu un scanner de codes-barres.

13. Installation selon l'une des revendications 4 à 12, en combinaison avec un outil d'extraction de broche destiné à extraire d'un adaptateur de vérification (7 ; 8) une broche ayant été localisée, cet outil d'extraction de broche présentant une douille (36) qui est pourvue d'une partie de poignée (40) et dont les dimensions intérieures sont adaptées à la tête de broche (12), en vue de saisir la tête de broche en y adhérant par friction.

14. Installation selon la revendication 13, **caractérisée en ce que** la douille (36) est réalisée, à l'extérieur, de manière à se rétrécir en direction de l'extrémité libre.

15. Installation selon la revendication 13 ou la revendication 14, **caractérisée en ce que** la douille (36) est d'un seul tenant.

16. Installation selon l'une des revendications 13 à 15, **caractérisée en ce que** la douille (36) est réalisée en métal, par exemple en titane ou en acier.

17. Installation selon l'une des revendications 13 à 16, **caractérisée en ce que** la partie de poignée (40) présente une dimension extérieure plus grande par rapport au restant de la douille (36).

18. Installation selon l'une des revendications 13 à 17, **caractérisée en ce que** sur la partie de poignée (40) est rapporté un revêtement (42) en matière plastique ou en caoutchouc.

19. Installation selon l'une des revendications 13 à 18, **caractérisée en ce que** la douille (36) possède un alésage (41) qui la traverse en s'étendant sur la totalité de sa longueur axiale.
